(19)

Europäisches
Patentamt
European
Patent Office
Office européen
des brevets

(11) **EP 2 157 694 A1**

(12) **EUROPEAN PATENT APPLICATION**

(43) Date of publication:
**24.02.2010 Bulletin 2010/08**

(51) Int Cl.:
***H03H 11/36*** *(2006.01)*

(21) Application number: **08290785.8**

(22) Date of filing: **19.08.2008**

(84) Designated Contracting States:
**AT BE BG CH CY CZ DE DK EE ES FI FR GB GR
HR HU IE IS IT LI LT LU LV MC MT NL NO PL PT
RO SE SI SK TR**
Designated Extension States:
**AL BA MK RS**

(71) Applicant: **NXP B.V.
5656 AG Eindhoven (NL)**

(72) Inventor: **The designation of the inventor has not
yet been filed**

(74) Representative: **Williamson, Paul Lewis
NXP Semiconductors UK Ltd.
Intellectual Property Department
Betchworth House
57-65 Station Road
Redhill
Surrey RH1 1DL (GB)**

(54) **RF Splitter**

(57)     RF splitter is disclosed which comprises a pseudo-transmission line (31) and two amplification blocks (32,33) to output respective amplified output signals. Such an RF splitter allows for independent control of multiple outputs. In one embodiment the splitter comprises a variable gain amplifier on at least one output stage. A variable load resistance (Rload1,Rload2) can provide for output network matching.

Fig. 3

EP 2 157 694 A1

**Description**

Field of the Invention

This invention relates to the field of RF signal splitters. It is particularly useful for broadband applications such as CATV (Community Antenna Television) distribution systems, multi tuner cable set-top boxes, cable splitter modules, multi tuner televisions, and home gateways.

Background of the Invention

RF splitters are useful in a wide range of applications, including multi tuner cable set-top boxes, cable splitter modules, multi tuner televisions and home gateways. Typically in such RF splitters a single input is split into multiple separate paths, the separate output paths can include, but are not limited to, a main picture tuner, a picture-in-picture (PIP) tuner, digital video recorders (DVR), and cable modems (CM). They are also widely used in CATV systems. Such systems are **characterised in that** the input signal may have a wide range of frequencies - that is, it may be considered as a broadband signal.

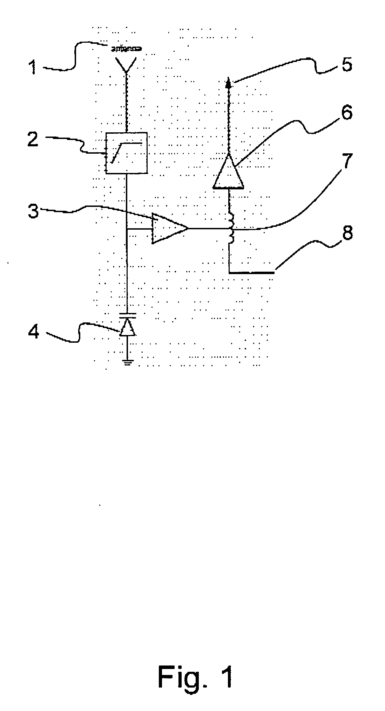

Conventional RF splitters comprise discrete passive splitters, which are then followed by separate fixed gain amplifiers. Such an RF splitter, which is commonly supplied in RF can tuner devices, is shown in Figure 1. As shown in the figure, an antenna 1 is electrical connected to splitter 3 via a high pass filter 2. The high pass filter is grounded via a surge protection diode 4 which provides protection against current, voltage, or power surges. The splitter directs the signal to the a midtapping of an inductor 7, one end of which is directed to an first RF output 8, and the other end of which is directed, via buffer amplifier 6, to a second RF output or phono output 5.

Such systems do not fulfil all of the following challenging performance desiderata:

firstly, the input splitter should maintain good matching performance, independently of the number of outputs which are used and the load on the respective used outputs; typically, existing passive splitters suffer from variable impedance matching which directly impacts their performance;

secondly, the RF splitter should perform linearly, and maintain a high signal-to-noise ratio (SNR); frequently these characteristics are degraded with conventional RF splitters, when the number of outputs exceeds two. The RF signal is often degraded due to poor isolation between each path, and the addition of non linearity and noise;

thirdly, it is often desirable to enable variable and different gain to be applied to each of the outputs without impacting the other outputs.

One approach to improving the performance of RF splitters is disclosed in United States patent document US-A-4,769,618. This document discloses a power divider, which includes an input transmission line having series-connected impedance elements. An RF splitter as proposed in US 4,769,618 is shown in figure 2. As shown the input power line 10 is connected through an active device (a field effect transistor FET 18) to an output transmission line 12. In order to split the RF input signal into N RF output signals, this sub-circuit comprising series-connected impedance 14, FET 18, and output transmission line 12, is replicated N times. Thus the splitter acts as a power divider which divides the input power by a ratio N.

Although this configuration provides an improvement on the conventional RF splitter, it does not readily enable a variable and different gain to be provided on each of the outputs, without interaction on the remainder of the outputs.

There thus remains an ongoing requirement for an RF splitter which does not suffer to the same extent from the above problem.

Summary of the invention

It is an object of the present invention to provide a variable signal level RF splitter, which is capable of operation across a wide range of frequencies, and output conditions, whilst maintaining good input matching.

According to the invention there is provided an RF splitter comprising a pseudo-transmission line connected to an input, the pseudo-transmission line comprising a plurality of series-connected sections, wherein each section comprises an inductive element arranged along the section and an amplifier connected between the section and a respective output. By this means, the above object may be achieved.

Preferably, each amplifier is a variable gain amplifier. This configuration allows particular advantage to be taken of the non-interdependence of the amplifier stages. To this end, beneficially, each amplifier may be configured to maintain a fixed input capacitance independent of the gain of the amplifier

Preferably, the amplifier is configured with a variable load.

Beneficially, the amplifier may comprise a first transistor, having a gate connected to the transmission line and a drain connected to the commonly connected sources of a pair of transistors, the pair of transistors having respective gate controls, one of the pair of transistor having its drain directly connectable to a supply voltage and the other of the pair of transistors having its drain connected both to the respective output and to a resistance, which resistance is connectable to the supply voltage. Such a two stage amplifier is particularly convenient for CATV distribution systems. Alternatively, the arrangement may have the drains and sources of the transistor interchanged, relative to that described above.

Preferable, the RF splitter includes a termination resistance at an end of the pseudo-transmission line.

These and other aspects of the invention will be apparent from, and elucidated with reference to, the embodiments described hereinafter.

Brief description of Drawings

An embodiment of the invention will be described, by way of example only, with reference to the drawings, in which

Fig. 1 illustrates a conventional splitter based on passive components;

Fig. 2 shows schematically an RF splitter according to the prior art;

Fig. 3 shows schematically an RF splitter according to the present invention;

Fig. 4 shows a comparison between a conventional pseudo transmission line (fig. 4(a)), and a pseudo transmission line incorporating amplifiers in accordance with the invention (fig. 4(b));

Fig. 5 shows an amplifier with a variable load;

Fig. 6 shows a circuit arrangement for an amplifier with a variable gain; and

Fig. 7 shows the equivalent circuit for the amplifier in fig. 6.

It should be noted that the Figures are diagrammatic and not drawn to scale. Relative dimensions and proportions of parts of these Figures have been shown exaggerated or reduced in size, for the sake of clarity and convenience in the drawings. The same reference signs are generally used to refer to corresponding or similar feature in modified and different embodiments

Detailed description of embodiments

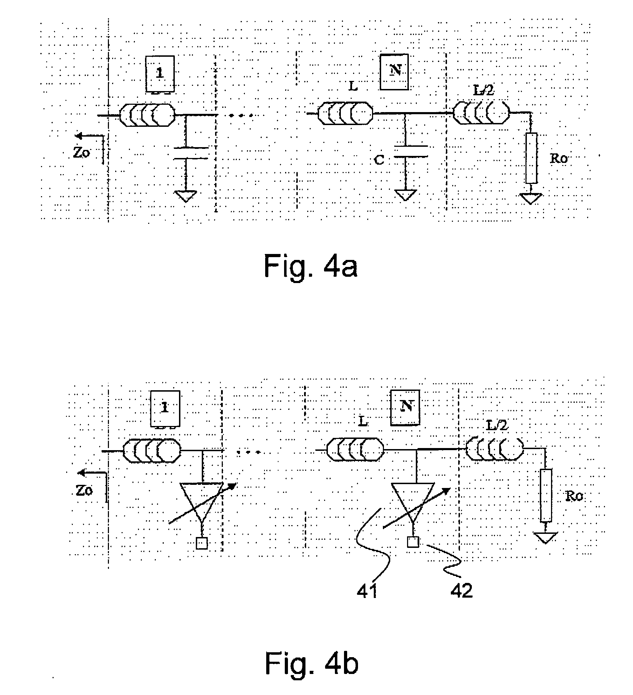

Fig. 4 illustrates, from one viewpoint, an embodiment of the invention. At fig. 4(a) a conventional pseudo transmission line is shown with characteristic impedance Zo, having N sub-sections; typically, the characteristic impedance Zo is either 50 $\Omega$ or 75 $\Omega$.

A pseudo transmission line exhibits properties which are similar to that of a real transmission line, up to a certain cut-off frequency, which is characteristic of the line. The cut off frequency $fc$ is given by $fc=1/(\pi\sqrt{(Lg.Cg)})$.

As shown in fig. 4(a), the transmission line may be represented by a series of N sub-sections, each subsection having an inductive element L arranged along the transmission line, together with a capacitive element C connecting the transmission line to ground. At the end of the transmission line there is a termination comprising a series inductor L/2, and a termination impedance Ro.

In comparison with the pseudo transmission line shown in fig. 4(a), an RF splitter according to this embodiment of the invention is shown at fig. 4(b) as a pseudo transmission line wherein the capacitive elements are replaced by variable gain amplifiers, between the inductive series elements of the line and respective outputs of the splitter. Thus, for each sub-section having a series inductance L, there is a variable gain amplifier 41, connected to a respective output 42 from the splitter. Thus, the pseudo line is only created at the input and the common signal path.

The RF splitter according to this embodiment provides impedance matching over a broad bandwidth, as well as a signal split function at each output gain stage. Theoretically, the number of outputs can be increased indefinitely, by adding more stages, without any loss of bandwidth. Moreover, since the amplifiers do not interact, the isolation between each stage is maintained through the intrinsic property of each sub-section, which presents the same impedance to each amplifier.

As discussed above, a pseudo-transmission line according to the embodiment of the invention provides impedance matching over a broad bandwidth. Each subsection has characteristic impedance:

$$Zc=\sqrt{(Lg/Cg)},$$

where Lg and Cg are the inductance and capacitance of the subsection, respectively. Provided that the operating frequency, $fop$, obeys:

$$fop < 0.8 \times fc,$$

where $fc$ is the cutoff frequency defined above, the pseudo transmission line property is maintained.

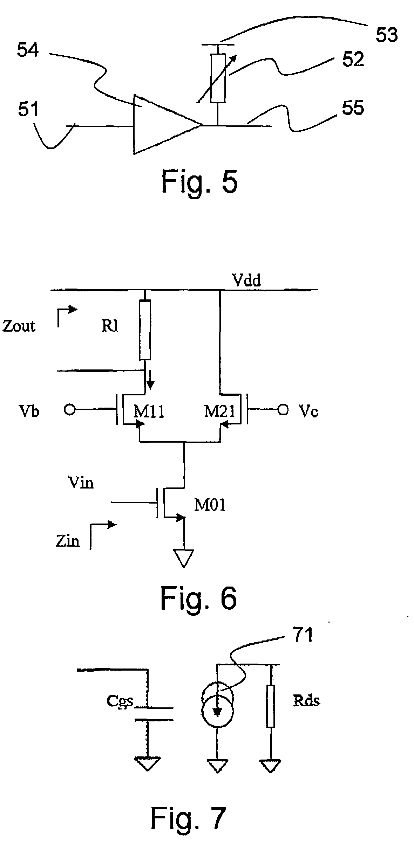

In the embodiment of the invention, the pseudo-transmission line is formed by integrating a gate capacitance, (Cgs), of the FET, with the inductance Lg. (Cgs will be defined below, with reference to Figures 6 and 7.) Thus, provided that the bias conditions are maintained for the FET, or its size is chosen appropriately, such that Cgs remains constant, the pseudo-transmission line properties hold good. As a consequence, the matching can be maintained across the full range of operation.

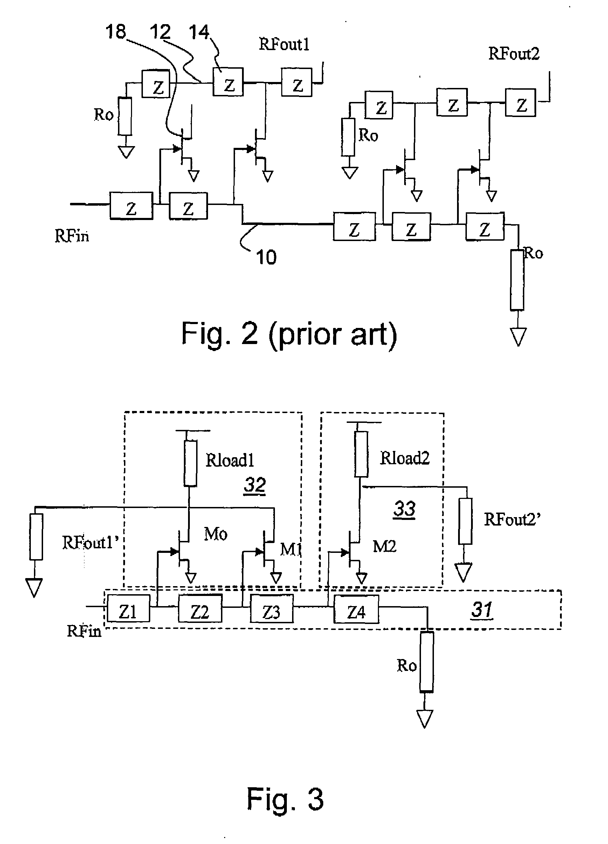

A splitter according to an embodiment of the invention is shown in figure 3. Figure 3 shows a pseudo transmission line, comprising a plurality of sub-sections with impedances Z1, Z2, Z3 and Z4. Shown in the figure are two output sub-circuits: the first comprises the sub-circuit of transistors M0 and M1, resistor Rload1, and output RFout1'; the second comprises transistor M2, resistor Rload2, and output RFout2'. In this embodiment, the first output sub-circuit is a two-stage distributed amplifier involving a first amplification by means of transistor M0, followed by a second amplification by means of transistor M0; Rload acts as a variable load resistance, which is varied in order to provide matching; the second output sub-circuit is a based on a single stage amplifier, the amplification being by means of transistor M2. It will be immediately apparent to the skilled person that various equivalents can be used in place of the two-stage amplifier and single stage amplifier shown: for instance, one or more single stage amplifier output circuits may be utilised in conjunction with one or more two stage amplifiers. Thus the circuit shown in Figure 3 is exemplary only, and not limiting, in particular as regards the configuration of output stages from the pseudo-transmission line.

As discussed above, the presence of the variable load (Rload1, Rload2) allows matching in the output network, and thus the outputs are not interdependent. Thus, in contrast to the prior art pseudo transmission line shown in Figure 2, in which changes to the gain affects Cgs and directly impacts the input matching condition, in the embodiment shown in figure 3, the load resistance Rload is varied in order to change the gain, which does not effect Cgs.

As described above with reference to Figure 4, provided only the input capacitance impedance of each amplifier section is maintained, the amplifier may provide variable gain, without any impact on the remainder of the pseudo transmission line RF splitter. This can be achieved by providing a variable load on the amplification elements, as indicated in fig. 5. Fig. 5 shows an amplifier 54 connected between a spur 51 from the transmission line. The output from the amplifier 54 is connected to ground 53 by means of variable load resistance 52; the output from the stage is shown at 55.

A specific implementation of a variable gain amplifier for use in the embodiment of the invention is shown in fig. 6. Fig. 6 shows a transistor M0, the source of which is connected to RF ground. The gate of the transistor is connected to the input voltage; that is to say to a spur of the pseudo transmission line. The drain of transistor M01 is connected to the common source connection of a pair of transistors M11 and M21, which are used to provide the variable gain. The variable gain control is provided by the gate connections to the transistor pair M11 and M21; a control voltage Vb being connected to the gate of M11, and a control voltage Vc being connected to the gate of M21. The drain of transistor M21 is connected directly to the voltage supply rail Vdd; that of transistor M11 is connected by means of load resistance R1. An RF output is provided at the drain node of transistor M1. This RF output has a characteristic impedance Zout; the characteristic impedance of the RF input voltage to M01 is equivalently denoted Zin.

The circuit described above providing variable gain control thus carries out the function of splitter programmable gain. Splitter programmable gain is a useful feature for the splitter, since when used in conjunction with automatic gain control (AGC) in a downstream tuner, the overall dynamic range can be increased.

Smooth changes in gain adjustment, or small steps in the gain, are important in some applications. For example analog TV reception can be sensitive to abrupt or sudden gain changes. However, such variable gain control is conventional difficult to implement, since gain changes has direct effects on impedance matching.

The equivalent circuit for this configuration is simple, as depicted in fig. 7: it consists of a gate-source capacitance Cgs, and a drain-source resistance Rds, which is in parallel with a constant current generator 71.

From reading the present disclosure, other variations and modifications will be apparent to the skilled person. Such variations and modifications may involve equivalent and other features which are already known in the art of RF splitters and which may be used instead of, or in addition to, features already described herein.

Although the appended claims are directed to particular combinations of features, it should be understood that the scope of the disclosure of the present invention also includes any novel feature or any novel combination of features disclosed herein either explicitly or implicitly or any generalisation thereof, whether or not it relates to the same invention as presently claimed in any claim and whether or not it mitigates any or all of the same technical problems as does the present invention.

Features which are described in the context of separate embodiments may also be provided in combination in a single embodiment. Conversely, various features which are, for brevity, described in the context of a single embodiment, may also be provided separately or in any suitable sub-combination.

The applicant hereby gives notice that new claims may be formulated to such features and/or combinations of such features during the prosecution of the present application or of any further application derived therefrom.

For the sake of completeness it is also stated that the term "comprising" does not exclude other elements or steps, the term "a" or "an" does not exclude a plurality, and reference signs in the claims shall not be construed as limiting the scope of the claims.

**Claims**

1. An RF splitter comprising a pseudo-transmission line (31) connected to an input, the pseudo-transmission line comprising a plurality of series-connected sections, wherein each section comprises an inductive element (Z1,Z2, Z3, Z4) arranged along the section and an amplifier (32, 33) connected between the section and a respective output (RFout1', RFout2').

2. An RF splitter according to claim 1, wherein each amplifier is a variable gain amplifier.

3. An RF splitter according to claim 2, wherein each amplifier is configured to maintain a fixed input capacitance independent of the gain of the amplifier

4. An RF splitter according to claim 3, wherein the amplifier is configured with a variable load (Rload1,

**EP 2 157 694 A1**

Rload2).

5. An RF splitter according to claim 2 or claim 3, wherein the amplifier comprises a first transistor (M01), having a gate connected to the transmission line and a drain connected to the commonly connected sources of a pair of transistors (M11, M21), the pair of transistors having respective gate controls (Vb, Vc), one (M21) of the pair of transistor having its drain directly connectable to a supply voltage (Vdd) and the other (M11) of the pair of transistors having its drain connected both to the respective output and to a resistance (R1), which resistance is connectable to the supply voltage (Vdd).

6. An RF splitter according to claim 2 or claim 3, wherein the amplifier comprises a first transistor (M01), having a gate connected to the transmission line and a source connected to the commonly connected drains of a pair of transistors (M11, M21), the pair of transistors having respective gate controls (Vb, Vc), one (M21) of the pair of transistor having its source directly connectable to a supply voltage (Vdd) and the other (M11) of the pair of transistors having its source connected both to the respective output and to a grounded resistance (R1, which resistance is connectable to the supply voltage (Vdd)).

7. An RF splitter according to any preceding claim, further including a termination resistance at an end of the pseudo-transmission line.

1

antenna

5

2

6

7

3

8

4

Fig. 1

Fig. 2 (prior art)

Fig. 3

Fig. 4a

Fig. 4b

Fig. 5

Fig. 6

Fig. 7

Europäisches
Patentamt

European
Patent Office

Office européen
des brevets

# EUROPEAN SEARCH REPORT

**Application Number**

EP 08 29 0785

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2008/069785 A (THOMSON LICENSING [FR]; SARAPIN ALEXANDER [US]) 12 June 2008 (2008-06-12) * page 2, lines 27-33; figures 1,3 * * page 3, lines 1-5 * * page 4, lines 1-3 * * page 5, lines 16-20 * ----- | 1,2,7 | INV. H03H11/36 |
| D,X | US 4 769 618 A (PARISH ROBERT M [US] ET AL) 6 September 1988 (1988-09-06) | 1,7 | |
| Y | * column 1, line 39 - column 2, line 23 * * column 3, lines 3-22,39-43; figure 1 * * column 4, lines 1-4,45-67 * ----- | 2-6 | |
| Y | JIANHONG XIAO ET AL: "A High Dynamic Range CMOS Variable Gain Amplifier for Mobile DTV Tuner" IEEE JOURNAL OF SOLID-STATE CIRCUITS, vol. 42, no. 2, 1 February 2007 (2007-02-01), pages 292-301, XP011161685 * section III. A * * figures 1a,b,5b * ----- | 2-6 | |

|  |  |  | **TECHNICAL FIELDS SEARCHED (IPC)** |
|---|---|---|---|
|  |  |  | H03H H03F H03G |

The present search report has been drawn up for all claims

| Place of search | Date of completion of the search | Examiner |
|---|---|---|
| Munich | 12 January 2009 | Maget, Judith |

EP 2 157 694 A1

## ANNEX TO THE EUROPEAN SEARCH REPORT
## ON EUROPEAN PATENT APPLICATION NO.

EP 08 29 0785

This annex lists the patent family members relating to the patent documents cited in the above-mentioned European search report.
The members are as contained in the European Patent Office EDP file on
The European Patent Office is in no way liable for these particulars which are merely given for the purpose of information.

12-01-2009

| Patent document cited in search report | | Publication date | Patent family member(s) | Publication date |
|---|---|---|---|---|
| WO 2008069785 | A | 12-06-2008 | NONE | |
| US 4769618 | A | 06-09-1988 | NONE | |

EPO FORM P0459

For more details about this annex : see Official Journal of the European Patent Office, No. 12/82

11

**EP 2 157 694 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 4769618 A